# EUROPEAN PATENT APPLICATION

(11) **EP 4 823 263 A1**
(43) Date of publication of application: **14.10.2026**
(21) Application number: 26170970.3
(22) Date of filing: 07.04.2026
(51) Int. Cl.: H05K 7/20

(54) **ELECTRONIC CIRCUIT BOARD AND IMMERSION COOLING APPARATUS THEREFOR**

(30) Priority: 07.04.2025 KR 20250044991
(71) Applicant: SK Innovation Co., Ltd., Seoul 03188 (KR)
(72) Inventor: KOO, Ja Cheol, 34124 Daejeon (KR); KIM, Byung Soo, 34124 Daejeon (KR); KIM, Hong Chan, 34124 Daejeon (KR); JEONG, Wan Ju, 34124 Daejeon (KR); CHO, June Ho, 34124 Daejeon (KR)
(74) Representative: Prüfer & Partner mbB Patentanwälte · Rechtsanwälte

(57) **Abstract**

An immersion cooling apparatus (100) according to an embodiment of the present disclosure includes a housing (110) configured to store a cooling fluid (10) therein; a plurality of electronic circuit boards (120) disposed inside the housing (110) to be immersed in the cooling fluid (10); and a heat exchange device (130) configured to perform heat exchange with the cooling fluid (10) having absorbed heat from the plurality of electronic circuit boards (120). At least one of the plurality of electronic circuit boards (120) includes a substrate (121); a plurality of electronic components (122) disposed on the substrate (121); and at least one coalescing unit (123) disposed between the plurality of electronic components (122), the at least one coalescing unit (123) being configured to coalesce at least one first vapor bubble (21) that is generated by heat of an electronic component (122) located at a lower position among the plurality of electronic components (122) and rises in an vertical direction of the housing (110).

## Description

### BACKGROUND

### Technical Field

The present disclosure relates to an electronic circuit board and an immersion cooling apparatus therefor.

### Technical Considerations

With the advancement of cutting-edge technologies such as the Internet of Things (IoT), Artificial Intelligence (AI), 5th Generation (5G) mobile communication, and streaming technology, the development of high-performance chips (e.g., integrated circuits (ICs)) is accelerating. While such high-performance chips feature high integration density and processing speeds to improve computing power, they also face the problem of increased heat generation. For example, in a high-density chip structure, heat dissipation is restricted, causing overheating problems, which can lead to degradation of system performance and stability.

Immersion cooling technology has recently gained increasing attention as a solution to the heat generation problem of high-performance chips. This technology can efficiently remove heat by immersing a substrate (or board), on which high-performance chips are mounted, in a non-conductive cooling fluid (e.g., dielectric fluid or dielectric coolant).

Meanwhile, during immersion cooling, the cooling fluid that has absorbed heat from a chip located at a lower portion may rise (flow) from the lower portion to an upper portion. In this case, the heat removal efficiency of a chip located at the upper portion may be degraded. For instance, when a plurality of substrates are immersed in the cooling fluid adjacent to each other (e.g., spaced apart by a predetermined interval), vapor bubbles generated by the heat of a chip located on one substrate may adhere (or accumulate) to one surface (e.g., a rear surface) of another substrate positioned along the rising path of the vapor bubbles. Due to such a vapor adhesion phenomenon, vapor pockets or a thin vapor film may be generated on a surface of the other substrate, which may deteriorate heat dissipation performance. Consequently, the cooling efficiency of the immersion cooling apparatus may be reduced.

### SUMMARY

Embodiments of the present disclosure may provide an electronic circuit board and an immersion cooling apparatus therefor, capable of improving cooling efficiency.

According to an aspect of the present disclosure, there is provided an immersion cooling apparatus, the apparatus comprising: a housing configured to store a cooling fluid therein; a plurality of electronic circuit boards disposed inside the housing to be immersed in the cooling fluid; and a heat exchange device configured to perform heat exchange with the cooling fluid having absorbed heat from the plurality of electronic circuit boards. At least one of the plurality of electronic circuit boards comprises: a substrate; a plurality of electronic components disposed on the substrate; and at least one coalescing unit disposed between the plurality of electronic components, the at least one coalescing unit being configured to coalesce at least one first vapor bubble that is generated by heat of an electronic component located at a lower position among the plurality of electronic components and rises in a vertical direction of the housing.

In some non-limiting embodiments, the at least one first vapor bubble may be coalesced by the at least one coalescing unit until reaching a predetermined size, and a second vapor bubble as the coalesced vapor bubble having the predetermined size may detach from the at least one coalescing unit and rise again in the vertical direction.

In some non-limiting embodiments, a buoyant force of the second vapor bubble exceeds an adhesive force between the second vapor bubble and an adjacent substrate such that the second vapor bubble does not adhere to the adjacent substrate upon contact therewith.

In some non-limiting embodiments, the plurality of electronic circuit boards may be disposed to be inclined at an angle within a tilt angle range determined by a specified equation. The tilt angle range may be calculated based on a length of the substrate, an interval between the substrates, a horizontal length of the coalescing unit, and a height of the coalescing unit.

In some non-limiting embodiments, each of the at least one coalescing unit may comprise: a base coupled to the substrate; and a coalescing plate coupled to the base at a predetermined angle and configured to coalesce the at least one first vapor bubble. The predetermined angle may be determined in consideration of at least one of an inclination of the substrate, an interval between the substrates, and an amount, a size, and a moving speed of the first vapor bubble.

In some non-limiting embodiments, the coalescing plate may be formed in a vane structure having a regular pattern.

In some non-limiting embodiments, the coalescing plate may be formed in a vane structure having an irregular pattern.

In some non-limiting embodiments, the coalescing plate may comprise a solid plate.

In some non-limiting embodiments, each of the at least one coalescing unit may further comprise an angle adjustment unit configured to adjust an angle between the base and the coalescing plate. Furthermore, each of the at least one coalescing unit may further comprise an elastic member configured to maintain the angle adjustment unit in a default state; and a stopper configured to limit rotation of the coalescing plate beyond a predetermined range.

In some non-limiting embodiments, the elastic member is replaceable.

In some non-limiting embodiments, each of the at least one coalescing unit further comprises a drive module configured to control an angle between the base and the coalescing plate.

In some non-limiting embodiments, the drive module comprises a motor.

In some non-limiting embodiments, the at least one coalescing unit may be located at an upper end of at least one electronic component, among the plurality of electronic components, that overlaps with another substrate in the vertical direction.

In some non-limiting embodiments, the substrate may further comprise a blocking structure disposed between the plurality of electronic components and configured to limit movement or flow of the cooling fluid.

According to another aspect of the present disclosure, there is provided an electronic circuit board, the board comprising: a substrate; a plurality of electronic components disposed on the substrate; and at least one coalescing unit disposed between the plurality of electronic components, the at least one coalescing unit being configured to coalesce at least one first vapor bubble generated by heat of an electronic component located at a lower position among the plurality of electronic components during immersion cooling.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a schematic diagram illustrating a configuration of an immersion cooling apparatus according to some non-limiting embodiments or aspects according to the principles of the present disclosure.
FIG. 2 is a diagram illustrating an electronic circuit board according to some non-limiting embodiments or aspects according to the principles of the present disclosure.
FIG. 3 is a diagram illustrating a positional relationship between an inclination of an electronic circuit board and a coalescing unit according to some non-limiting embodiments or aspects according to the principles of the present disclosure.
FIG. 4 is a diagram illustrating various shapes of a coalescing unit according to some non-limiting embodiments or aspects according to the principles of the present disclosure.
FIG. 5 is a diagram illustrating an example of a coalescing unit according to some non-limiting embodiments or aspects according to the principles of the present disclosure.

### DETAILED DESCRIPTION

Hereinafter, embodiments or aspects will be described in detail with reference to the accompanying drawings. However, since various changes may be made in the embodiments or aspects, the scope of the patent disclosure is not limited or restricted by these embodiments or aspects. It should be understood that all modifications, equivalents, and alternatives for the embodiments or aspects are comprised in the scope of the present disclosure. For example, it is to be understood that the present disclosure may assume various alternative variations and step sequences, except where expressly specified to the contrary. It is also to be understood that the specific devices and processes illustrated in the attached drawings, and described in the following detailed description, are simply exemplary and non-limiting embodiments or aspects of the disclosed subject matter. Hence, specific dimensions and other physical characteristics related to the embodiments or aspects disclosed herein are not to be considered as limiting.

No aspect, component, element, structure, act, step, function, instruction, and/or the like used herein should be construed as critical or essential unless explicitly described as such. Also, as used herein, the articles "a" and "an" are intended to include one or more items and may be used interchangeably with "one or more" and "at least one". Where only one item is intended, the term "one" or similar language is used. Also, as used herein, the terms "comprise", "comprises", "comprising", "include", "includes", "including", "has", "have", "having", "provides", "provide", "providing" or the like are intended to be open-ended terms. Further, the phrase "based on" is intended to mean "based at least partially on" unless explicitly stated otherwise. In addition, reference to an action being "based on" a condition may refer to the action being "in response to" the condition. For example, the phrases "based on" and "in response to" may, in some non-limiting embodiments or aspects, refer to a condition for automatically triggering an action (e.g., a specific operation of an electronic device, such as a computing device, a processor, and/or the like).

It will be understood that when a component is described as being "connected", "combined" or "coupled" to another component, the component may be directly connected or coupled to the another component, but it may be "connected", "combined" or "coupled" to the another component by an intervening another component that may be present.

Also, as used herein, the terms "upper", "upward", "lower", "bottom", "side", "right", "left" or the like are used with reference to the respective positions or orientations, respectively, shown in the drawings for representing a positional relationship in the given context. Specifically, the terms "upper", "lower", and "bottom" refer to a height direction perpendicular to a planar directions. In a three-dimensional Cartesian coordinate system, the planar directions corresponds to the X direction and to the Y direction, and the height direction to the Z direction. For instance, the Z direction may represent a vertical direction in which bubbles may move upward.

Further, in describing the components of the embodiment or aspect, the meaning of "or" may mean each of the components, may mean two or more of the components, or may mean all of the components. For example, it should be understood that the expressions "a, b or c" represent any one of "a", "b", "c", "a and b", "a and c", "b and c", and "a, b and c".

Components comprised in one embodiment or aspect and components comprising common functions will be described using the same names in other embodiments or aspects. The description given in one embodiment or aspect may be applied to other embodiments or aspects, and therefore will not be described in detail within the overlapping range, unless there is a description opposite thereto.

The device and/or 'data' processed by the device may be expressed in terms of 'information". Here, the information may be used as a concept comprising the data.

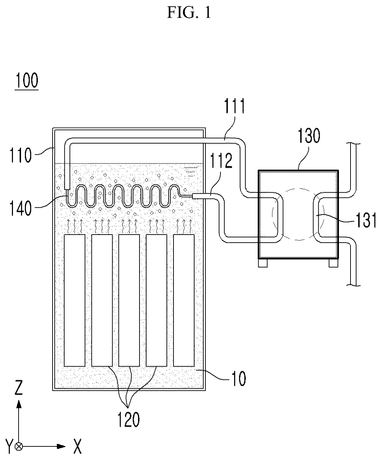

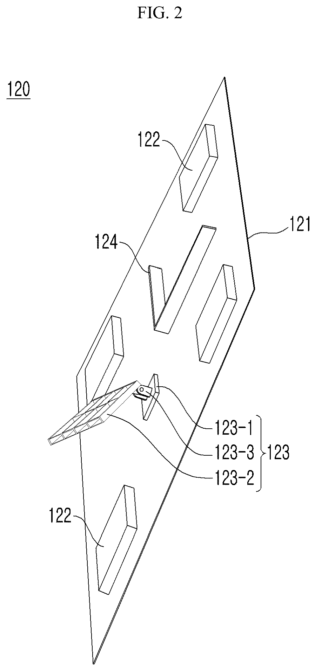

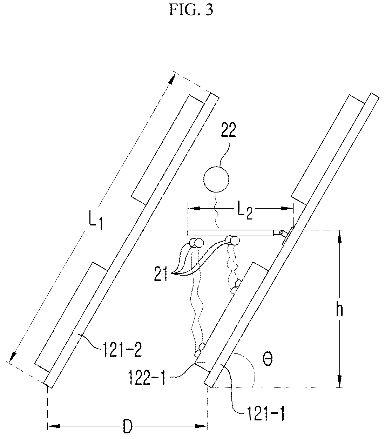

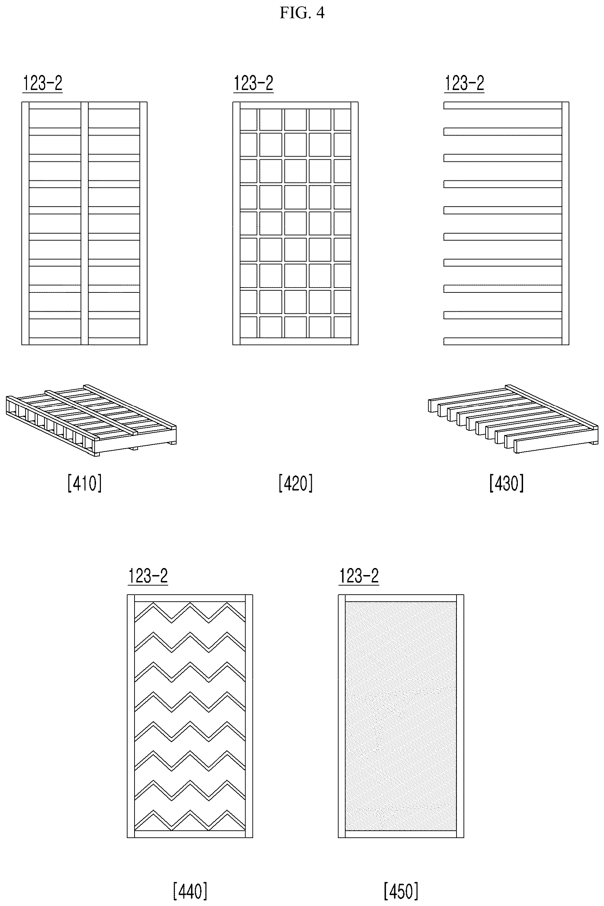

FIG. 1 is a schematic diagram illustrating a configuration of an immersion cooling apparatus according to an embodiment of the present disclosure, FIG. 2 is a diagram illustrating an electronic circuit board according to an embodiment of the present disclosure, FIG. 3 is a diagram for explaining a positional relationship between an inclination of the electronic circuit board and a coalescing unit according to an embodiment of the present disclosure, and FIG. 4 is a diagram illustrating various shapes of the coalescing unit according to an embodiment of the present disclosure.

Referring to FIGS. 1 to 4, an immersion cooling apparatus 100 according to an embodiment of the present disclosure may be of a 2-phase type in which a phase change of a cooling fluid 10 (e.g., dielectric fluid or dielectric coolant) occurs during an immersion cooling process (e.g., the cooling fluid 10 absorbs heat to be vaporized and is then converted back to a liquid by a condenser 140). The immersion cooling apparatus 100 may include a housing 110, a plurality of electronic circuit boards 120, a heat exchange device 130, and the condenser 140.

The housing 110 may store the cooling fluid 10 therein. The housing 110 may have, but is not limited to, a rectangular parallelepiped shape. For example, the housing 110 may have an internal space capable of accommodating a cooling target (e.g., the electronic circuit boards 120), and may store the cooling fluid 10 in the internal space so that a plurality of cooling targets (e.g., the plurality of electronic circuit boards 120) can be immersed therein.

At least a portion of an upper surface of the housing 110 may be formed to be openable and closable to insert or remove the cooling targets. The housing 110 may be sealed so that during cooling, the cooling fluid which has absorbed heat from the electronic circuit board (120) and undergone a phase change (hereinafter, referred to as vapor) does not leak to the outside.

The condenser 140 may be located in an empty upper space of the housing 110. The condenser 140 may be connected to the heat exchange device 130 through a first pipe 111 and a second pipe 112. According to an embodiment, the condenser 140 may perform heat exchange (e.g., absorb heat from the vapor) with the vapor (e.g., the cooling fluid 10 whose phase has been changed (e.g., vaporized) by the heat of the electronic circuit boards 120). The vapor from which heat has been removed by the condenser 140 may be condensed back into a liquid and fall under gravity. Meanwhile, although the first pipe 111 and the second pipe 112 are illustrated and described separately in FIG. 1, this is for convenience of description, and the first pipe 111 and the second pipe 112 may be formed as a single pipe. According to some embodiments, the condenser 140 may not be included in the immersion cooling apparatus 100. In this case, the cooling fluid having absorbed heat may move to the heat exchange device 130 outside the housing through the first pipe, perform heat exchange with the heat exchange device 130, and then return to the inside of the housing through the second pipe.

The heat exchange device 130 is located outside the housing 110 and may perform heat exchange. The heat exchange device 130 may cool a refrigerant (e.g., a refrigerant that has absorbed the heat of vapor) flowing in from the condenser 140 through heat exchange. For example, the heat exchange device 130 may perform heat exchange with the refrigerant flowing in through the first pipe 111 via a heat exchange medium 131. Specifically, the heat exchange device 130 may absorb heat from the refrigerant flowing in from the condenser 140 through the first pipe 111 to cool the refrigerant via the heat exchange medium 131, and provide the cooled refrigerant to the condenser 140 through the second pipe 112. As another example, when the immersion cooling apparatus 100 does not include the condenser 140, the heat exchange device 130 may perform heat exchange with the cooling fluid 10 flowing in through the first pipe 111. The heat exchange device 130 may discharge the cooling fluid 10, which has undergone heat exchange, into the housing 110 through the second pipe 112.

The plurality of electronic circuit boards 120 may be disposed inside the housing 110. For example, the plurality of electronic circuit boards 120 may be disposed inside the housing 110 so as to be immersed in the cooling fluid 10. Specifically, the plurality of electronic circuit boards 120 may be disposed inside the housing 110 to be spaced apart in a first direction (e.g., an X-axis direction or a Y-axis direction) while having an inclination at a predetermined angle (or mounting angle) with respect to a lower surface (or a bottom surface) of the housing 110.

Each of the plurality of electronic circuit boards 120 (hereinafter, each electronic circuit board) may include a plurality of electronic components (e.g., integrated circuit (IC) chips). Each electronic circuit board may include (e.g., have installed or disposed) a coalescing unit (e.g., a coalescer) at one side (e.g., between the electronic components) to limit and coalesce movement of a vapor bubble (e.g., a vapor bubble generated by nucleate boiling).

As illustrated in FIG. 2, each of the plurality of electronic circuit boards 120 may include a substrate 121, a plurality of electronic components 122, and a coalescing unit 123.

The plurality of electronic components 122 may be disposed (or mounted) on the substrate 121. The substrate 121 may include a printed circuit board (PCB), a flexible printed circuit board (FPCB), and the like.

The plurality of electronic components 122 may be disposed on the substrate 121. The plurality of electronic components 122 may include a central processing unit (CPU), a graphics processing unit (GPU), a power module, a memory (e.g., a random access memory (RAM), a read only memory (ROM), etc.), a storage medium (e.g., a hard disk, a solid state drive (SSD), etc.), a communication module, and the like, for configuring a system (e.g., a server). The plurality of electronic components 122 may generate heat during operation of the system, and the generated heat may be cooled by the cooling fluid 10. The degree of heat generation of the plurality of electronic components 122 may vary depending on performance. For example, the higher the integration degree and processing speed the plurality of electronic components 122 have, the more heat may be generated (e.g., a generation rate and/or a size of vapor bubbles may be increased).

The coalescing unit 123 may be located (or disposed) between the plurality of electronic components 122. For example, the coalescing unit 123 may be located at an upper end of at least one electronic component, among the plurality of electronic components 122, that overlaps with another substrate in a second direction (e.g., a Z-axis direction) (hereinafter, a vertical direction). In addition, the coalescing unit 123 may coalesce at least one vapor bubble that is generated by heat of an electronic component located at a lower position and rises in an upward direction of the housing 110. The coalescing unit 123 may be formed integrally with the substrate 121, or may be formed as a separate structure and then attached or coupled to the substrate 121.

According to an embodiment, the coalescing unit 123 may limit movement or flow of a vapor bubble (hereinafter, a first vapor bubble) 21 generated by heat of the electronic component 122. In other words, as illustrated in FIG. 3, the coalescing unit 123 may prevent first vapor bubbles 21 generated from a first substrate 121-1, among the plurality of substrates 121, from being attached to a second substrate 121-2. Specifically, when heat is generated in a first electronic component 122-1 of the first substrate 121-1, at least one first vapor bubble 21 may be generated on a surface of the first electronic component 122-1 (or a surface of a heat dissipator (e.g., a heat sink) covering the surface of the first electronic component 122-1 for heat dissipation) by a nucleate boiling phenomenon. The generated first vapor bubble 21 may rise (or float) in the vertical direction by a floating force (e.g., buoyancy of the first vapor bubble 21 and flow of the cooling fluid 10). The first vapor bubble 21 rising in the vertical direction may adhere (or accumulate) to the coalescing unit 123 blocking a moving path (or a rising path) of the first vapor bubble 21 (e.g., located on the moving path). The first vapor bubbles 21 may be coalesced on the coalescing unit 123 until reaching a predetermined size. In other words, the coalescing unit 123 intercepts first vapor bubbles 21 that would otherwise rise in an upward direction along a rising path toward the adjacent substrate 121. The coalescing unit 123 coalesces the first vapor bubbles 21 into a coalesced vapor bubble (i.e., a second vapor bubble 22) that detaches upon reaching a predetermined size (or a predetermined threshold (e.g., a threshold buoyancy at which point the coalesced vapor bubble will detach)), thereby preventing vapor adhesion to the adjacent substrate 121. As used herein, "the threshold buoyancy" is the point where buoyant force exceeds adhesive force.

According to an embodiment, the coalescing unit 123 may include a base 123-1 coupled (e.g., fixed) to the substrate 121 and a coalescing plate 123-2 to which the first vapor bubble 21 adheres and at which the first vapor bubble 21 is subjected to be coalesced. The coalescing plate 123-2 may be coupled (e.g., fixed) to the base 123-1 at a predetermined angle (or coalescing plate angle). The predetermined angle may be an angle determined (e.g., optimized) in consideration of an interval between the substrates 121 (hereinafter, a substrate interval) and/or an inclination angle of the substrate 121 so that the first vapor bubble 21 rising in the vertical direction can be easily adhered. The predetermined angle may be further determined in consideration of an amount (e.g., generation rate), a size (e.g., average size), and a moving speed of the first vapor bubbles 21 (or a moving speed of the cooling fluid 10). For example, as illustrated in FIG. 3, the predetermined angle may be an angle at which the coalescing plate 123-2 is horizontal to the bottom surface of the housing 110.

According to some embodiments, as illustrated in FIG. 2, the coalescing unit 123 may further include an angle adjustment unit (or angle adjustment mechanism) (e.g., a hinge) 123-3 capable of adjusting an angle between the base 123-1 and the coalescing plate 123-2. The angle adjustment unit 123-3 may appropriately adjust the angle between the base 123-1 and the coalescing plate 123-2 under the control of the immersion cooling apparatus 100 (or a user). The angle between the base 123-1 and the coalescing plate 123-2 may be adjusted based on the amount, size, and moving speed of the first vapor bubble 21 (or the moving speed of the cooling fluid 10), the inclination angle of the substrate 121, and/or the substrate interval.

According to an embodiment, the angle between the base 123-1 and the coalescing plate 123-2 may be automatically adjusted by the immersion cooling apparatus 100 (e.g., a drive module (e.g., a motor) (not shown) that controls driving (e.g., rotation) of the angle adjustment unit 123-3). For example, the immersion cooling apparatus 100 may check (or measure) temperatures or a temperature distribution of electronic components 122 provided on the substrate 121 using a temperature sensor, and control the angle between the base 123-1 and the coalescing plate 123-2 according to the checked temperatures or temperature distribution. The immersion cooling apparatus 100 may determine an angle according to the checked temperatures or temperature distribution from a mapping table in which temperatures (or temperature distributions) and angles are matched and stored, and adjust the angle between the base 123-1 and the coalescing plate 123-2 to the determined angle. According to some embodiments, the immersion cooling apparatus 100 may predict the angle using an Artificial Intelligence (AI) model. The AI model may include, but is not limited to, a regression model that learns a correlation between an input variable (e.g., temperature (or temperature distribution)) and an output variable (e.g., angle) using training data. The AI model may be trained by further considering at least one of the amount, size, and moving speed of the first vapor bubble 21 (or the moving speed of the cooling fluid 10), the inclination angle of the substrate 121, and the substrate interval as an input variable.

According to some embodiments, the angle between the base 123-1 and the coalescing plate 123-2 may be manually adjusted by a user.

Meanwhile, as illustrated in FIG. 3, the second vapor bubble 22 that coalesced to a predetermined size may detach from the coalescing unit 123 and rise again in the vertical direction. At this time, even if the second vapor bubble 22 comes into contact with the second substrate 121-2 (e.g., a rear surface of the second substrate 121-2) while rising again in the vertical direction, the second vapor bubble 22 may not be adhered to the second substrate 121-2. This is because a floating force (or buoyant force) (= buoyancy + moving speed of the cooling fluid 10 (or drag force from the flow of the cooling fluid 10)) of the second vapor bubble 22 is greater than an adhesive force of the second vapor bubble 22 attempting to adhere to the second substrate 121-2 (or an adhesive force between the second vapor bubble (22) and an adjacent substrate).

On the other hand, when the inclination angles of the first substrate 121-1 and the second substrate 121-2 are greater than or equal to a predetermined level (e.g., when the substrate 121 gradually moves from a vertical state to a horizontal state), the second vapor bubble 22 may not escape into a space between the first substrate 121-1 and the second substrate 121-2, and may adhere to the second substrate 121-2 or remain in the space between the first substrate 121-1 and the second substrate 121-2.

An inclination angle (Θ) of the first substrate 121-1 and the second substrate 121-2 at which the second vapor bubble 22 can smoothly rise to an upper space of the housing 110 (e.g., a position of the condenser 140) may be determined (calculated) by <Equation 1> and <Equation 2> below. <Equation 1> ${L}_{1} sin θ < D$ <Equation 2> ${L}_{2} tan θ < h$

In <Equation 1> and <Equation 2>, "L₁" denotes a length of the substrate 121 (e.g., a length in the height direction (Z-axis)), "D" denotes a substrate interval, "L₂" denotes a traverse length of the coalescing unit 123 (e.g., a horizontal length from a surface of the substrate 121 where the base 123-1 is installed to an end of the coalescing plate 123-2), and "h" denotes a height of the coalescing unit 123 (e.g., a height from a lowermost end of the substrate 121 to the coalescing unit 123).

According to an embodiment, the coalescing unit 123 (e.g., the coalescing plate 123-2) may have a structure capable of smoothly coalescing the first vapor bubble 21 up to a specified size (e.g., when the coalesced vapor bubble (e.g., second vapor bubble 22) reaches a threshold buoyancy). According to an embodiment, the coalescing plate 123-2 may be formed in a vane structure of a regular pattern or an irregular pattern. For example, as illustrated in FIG. 4, the coalescing plate 123-2 of the coalescing unit 123 may be formed in a vane structure of a ladder pattern 410, a mesh pattern 420, a comb pattern 430, or a wave pattern 440. According to some embodiments, the coalescing plate 123-2 may be formed in a vane structure of a flexible wire pattern. A size of the second vapor bubble 22 (or a rising speed of the second vapor bubble 22) may be adjusted according to a size (e.g., an interval) of the vane structure. According to some embodiments, the coalescing plate 123-2 may be formed as a solid plate 450.

Meanwhile, although FIGS. 2 and 3 illustrate and describe each substrate 121 as including one coalescing unit 123, each substrate 121 may include a plurality of coalescing units 123. On the other hand, some of the plurality of substrates 121 may not include the coalescing unit 123. For example, assuming that the plurality of substrates 121 are arranged in a horizontal direction (e.g., an X-axis direction) and the substrates 121 are inclined to the right, the leftmost substrate (e.g., the second substrate 121-2 in FIG. 3) may not include the coalescing unit 123.

The immersion cooling apparatus 100 described above disposes a coalescing unit 123 for coalescing vapor on a moving path of a cooling fluid (vapor) having absorbed heat from electronic components, thereby preventing a vapor adhesion phenomenon in which vapor adheres to an adjacent substrate located (e.g., overlapping) on the moving path of the vapor. The immersion cooling apparatus 100 can resolve temperature imbalance between electronic components 122 during immersion cooling, improve reliability, and improve cooling efficiency. In addition, the immersion cooling apparatus 100 can improve the lifespan of the electronic components 122 by effectively removing heat from the electronic components 122. As the lifespan of the electronic components 122 is improved, a frequency of maintenance may decrease (or a maintenance cycle may increase) and/or a cost of maintenance may decrease.

Meanwhile, as illustrated in FIG. 2, each substrate 121 may further include a blocking structure 124 (e.g., a baffle, rib, wall, or the like) that blocks (or restricts) the movement or flow of the cooling fluid 10 between the plurality of electronic components 122 thereby inhibiting convective transfer of heat via dielectric coolant 10 between adjacent electronic components 122 on the same substrate 121. Whereas the coalescing unit 123 intercepts vapor bubbles 21 rising from the plurality of electronic components 122, the blocking structure 124 inhibits convective transfer of heated cooling fluid 10 between vertically aligned electronic components 122 on the same substrate 121. The blocking structure 124 may be positioned between electronic components 122 that overlap along the rising path of the cooling fluid 10 among the plurality of electronic components 122 disposed on the substrate 121. The blocking structure 124 may prevent the cooling fluid 10, which has absorbed heat from an electronic component located at a lower position along the rising path of the cooling fluid 10, from moving toward an electronic component 122 located at an upper position, thereby preventing a decrease in the cooling efficiency of the electronic component 122 located at the upper position.

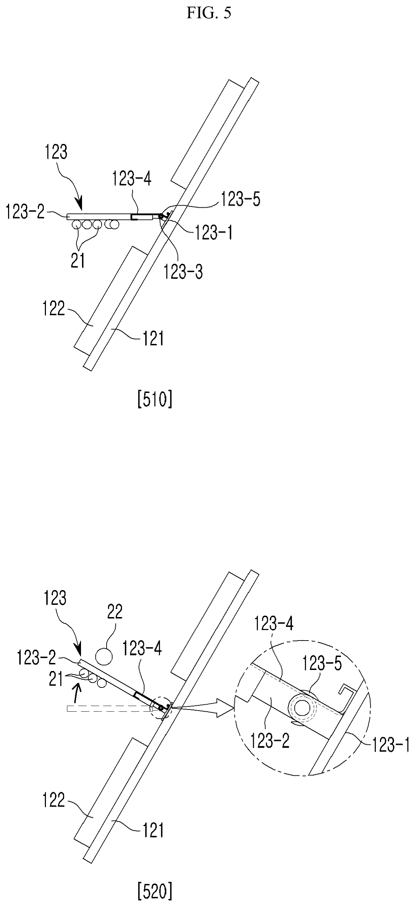

FIG. 5 is a diagram illustrating an example of a coalescing unit according to an embodiment of the present disclosure.

Referring to FIG. 5, the coalescing unit 123 according to an embodiment of the present disclosure may include a base 123-1, a coalescing plate 123-2, an angle adjustment unit 123-3, an elastic member (or biasing member) 123-4, and a stopper (or rotation limiter) 123-5.

A detailed description of the base 123-1, the coalescing plate 123-2, and the angle adjustment unit 123-3 has been described with reference to FIGS. 1 to 4, and thus will be omitted.

The elastic member 123-4 may maintain the angle adjustment unit 123-3 (e.g., a hinge) in a default state (e.g., a state in which the base 123-1 and the coalescing plate 123-2 are arranged at a default angle).

The stopper 123-5 (e.g., a catching projection) may limit rotation of the coalescing plate 123-2 beyond a predetermined range. For example, the stopper 123-5 may limit a rotation range of the coalescing plate 123-2 so that the coalescing plate 123-2 does not collide with another substrate (or an electronic component) when rotated by buoyancy of the vapor bubbles 21 and 22.

According to an embodiment, the coalescing plate 123-2 of the coalescing unit 123 may be rotated based on a rotation axis (e.g., a hinge axis) of the angle adjustment unit 123-3 by buoyancy of vapor bubbles coalesced on the coalescing plate 123-2. For example, when first vapor bubbles 21 are generated due to heat generated from the electronic component 122 included in the substrate 121 while the coalescing plate 123-2 is in the default state, the first vapor bubbles 21 may move upward and be coalesced on the coalescing plate 123-2, as illustrated in a drawing denoted by reference numeral 510. When the buoyancy of the vapor bubbles 21 and 22 coalesced on the coalescing plate 123-2 exceeds a tension of the elastic member 123-4, the coalescing plate 123-2 may be rotated in an upward direction based on the rotation axis of the angle adjustment unit 123-3, as illustrated in a drawing denoted by reference numeral 520. When the coalesced vapor bubbles 21 and 22 detach from the coalescing plate 123-2, the coalescing plate 123-2 may return to the default state by the tension of the elastic member 123-4.

According to some embodiments, the elastic member 123-4 may be replaceable. In this case, a degree of coalescence (e.g., an amount of coalescence) of the second vapor bubbles 22 coalesced on the coalescing plate 123-2 may be adjusted by replacing the elastic member 123-4 with an elastic member having a different tension.

The immersion cooling apparatus according to an embodiment of the present disclosure may have improved (e.g., increased) cooling efficiency. For example, it is possible to prevent heat dissipation of an adjacent substrate from being degraded due to adhesion of vapor (or a vapor droplet or bubble) of the cooling fluid, the phase of which is changed due to heat absorption, to the adjacent substrate. In this case, a vapor pocket or a thin vapor film is not formed between the substrate and the cooling fluid, and a heat transfer coefficient may be improved as the cooling fluid and the substrate directly contact each other.

In addition, the immersion cooling apparatus of the present disclosure can prevent a hot-spot region from being generated due to degradation of heat dissipation in a partial region of a specific substrate where a vapor pocket or a thin vapor film is formed by a vapor adhesion phenomenon. As described above, as the generation of the hot-spot region is prevented, temperature imbalance between substrates during immersion cooling can be resolved, and reliability of the immersion cooling can be improved. In addition, through improvement in the lifespan of electronic components, a frequency of maintenance may be decreased (or a maintenance cycle may be increased) and/or a cost of maintenance may be reduced.

The contents described above are merely examples applying the principles of the present disclosure, and other configurations may be further included without departing from the scope of the present invention. For example, at least some of the various embodiments of the present disclosure described above may be combined.

## Claims

1. An immersion cooling apparatus (100) comprising:
a housing (110) configured to store a cooling fluid (10) therein;
a plurality of electronic circuit boards (120) disposed inside the housing (110) to be immersed in the cooling fluid (10); and
a heat exchange device (130) configured to perform heat exchange with the cooling fluid (10) having absorbed heat from the plurality of electronic circuit boards (120),
wherein at least one of the plurality of electronic circuit boards (120) comprises:
a substrate (121);
a plurality of electronic components (122) disposed on the substrate (121); and
at least one coalescing unit (123) disposed between the plurality of electronic components (122), the at least one coalescing unit (123) being configured to coalesce at least one first vapor bubble (21) that is generated by heat of an electronic component (122) located at a lower position among the plurality of electronic components (122) and rises in a vertical direction of the housing (110).

2. The immersion cooling apparatus (100) of claim 1,
wherein the at least one first vapor bubble (21) is coalesced by the at least one coalescing unit (123) until reaching a predetermined size, and
wherein a second vapor bubble (22) as the coalesced vapor bubble having the predetermined size detaches from the at least one coalescing unit (123) and rises again in the vertical direction.

3. The immersion cooling apparatus (100) of claim 2, wherein a buoyant force of the second vapor bubble (22) exceeds an adhesive force between the second vapor bubble (22) and an adjacent substrate such that the second vapor bubble (22) does not adhere to the adjacent substrate upon contact therewith.

4. The immersion cooling apparatus (100) of any one of claims 1 to 3, wherein the plurality of electronic circuit boards (120) are disposed to be inclined at an angle within a tilt angle range determined by a specified equation,
preferably wherein the tilt angle range is calculated based on a length of the substrate (121), an interval between the substrates (121), a horizontal length of the coalescing unit (123), and a height of the coalescing unit (123).

5. The immersion cooling apparatus (100) of any one of claims 1 to 4, wherein each of the at least one coalescing unit (123) comprises:
a base (123-1) coupled to the substrate (121); and
a coalescing plate (123-2) coupled to the base (123-1) at a predetermined angle and configured to coalesce the at least one first vapor bubble (21),
preferably wherein the predetermined angle is determined in consideration of at least one of an inclination of the substrate (121), an interval between the substrates (121), and an amount, a size, and a moving speed of the first vapor bubble (21).

6. The immersion cooling apparatus (100) of claim 5, wherein the coalescing plate (123-2) is formed in a vane structure having a regular pattern or an irregular pattern.

7. The immersion cooling apparatus (100) of claim 5 or 6, wherein the coalescing plate comprises a solid plate (450).

8. The immersion cooling apparatus (100) of any one of the claims 5 to 7, wherein each of the at least one coalescing unit (123) further comprises an angle adjustment unit (123-3) configured to adjust an angle between the base (123-1) and the coalescing plate (123-2).

9. The immersion cooling apparatus (100) of claim 8, wherein each of the at least one coalescing unit (123) further comprises:
an elastic member (123-4) configured to maintain the angle adjustment unit (123-3) in a default state; and
a stopper (123-5) configured to limit rotation of the coalescing plate (123-2) beyond a predetermined range.

10. The immersion cooling apparatus (100) of claim 9, wherein the elastic member (123-4) is replaceable.

11. The immersion cooling apparatus (100) of claim 7, wherein each of the at least one coalescing unit (123) further comprises:
a drive module configured to control an angle between the base (123-1) and the coalescing plate (123-2).

12. The immersion cooling apparatus (100) of claim 11, wherein the drive module comprises a motor.

13. The immersion cooling apparatus (100) of any one of claims 1 to 12, wherein the at least one coalescing unit (123) is located at an upper end of at least one electronic component (122), among the plurality of electronic components (122), that overlaps with another substrate (121) in the vertical direction.

14. The immersion cooling apparatus (100) of any one of claims 1 to 13, wherein the substrate (121) further comprises a blocking structure (124) disposed between the plurality of electronic components (122) and configured to limit movement or flow of the cooling fluid (10).

15. An electronic circuit board (120) comprising:
a substrate (121);
a plurality of electronic components (122) disposed on the substrate (121); and
at least one coalescing unit (123) disposed between the plurality of electronic components (122), the at least one coalescing unit (123) being configured to coalesce at least one first vapor bubble (21) generated by heat of an electronic component (122) located at a lower position among the plurality of electronic components (122) during immersion cooling.
